# EUROPÄISCHE PATENTSCHRIFT

(11) **EP 1 922 322 B1**
(45) Veröffentlichungstag und Bekanntmachung des Hinweises auf die Patenterteilung: **28.11.2012**
(21) Anmeldenummer: 06792961.2
(22) Anmeldetag: 23.08.2006
(51) Int. Cl.: C07F 5/02, H05B 33/14

(54) **MATERIALIEN ZUR N-DOTIERUNG DER ELEKTRONENTRANSPORTSCHICHTEN IN ORGANISCHEN ELEKTRONISCHEN BAUELEMENTEN**
MATERIALS FOR N-DOPING THE ELECTRON-TRANSPORTING LAYERS IN ORGANIC ELECTRONIC COMPONENTS
MATIERES DE DOPAGE N DES COUCHES DE TRANSPORT D'ELECTRONS DANS DES COMPOSANTS ELECTRONIQUES ORGANIQUES

(30) Priorität: 05.09.2005 DE 102005042103
(43) Veröffentlichungstag der Anmeldung: 21.05.2008
(73) Patentinhaber: OSRAM Opto Semiconductors GmbH, 93055 Regensburg (DE)
(72) Erfinder: KANITZ, Andreas, 91315 Höchstadt (DE)
(74) Vertreter: Epping - Hermann - Fischer
(86) Internationale Anmeldenummer: PCT/EP2006/065580
(87) Internationale Veröffentlichungsnummer: WO 2007/028712

(56) Entgegenhaltungen:
- EP-A1- 1 142 895
- WO-A-2005/062675
- BLOUNT, JOHN F. ET AL: "Conformational analysis of triarylboranes" JOURNAL OF THE AMERICAN CHEMICAL SOCIETY , 95(21), 7019-29 CODEN: JACSAT; ISSN: 0002-7863, 1973, XP002410369

## Beschreibung

Die Erfindung betrifft neue Materialien zur Verbesserung der Elektroneninjektion und des Elektronentransportes in organischen Bauelementen wie organischen Leuchtdioden (OLEDs), organischen Feldeffekttransistoren (OFETs) und organischen Solarzellen.

In den letzten Jahren sind insbesondere für organische Leuchtdioden Materialien bekannt geworden, durch die die Elektroneninjektion sowie der Elektronentransport in OLEDs verbessert werden. (Lit.: S. Yamaguchi, S.Akiyama, K. Tamao, J. Am. Chem. Soc. 2000, 122, 6335-6336)

Die Druckschrift EP 1 142 895 A1 betrifft Boranderivate und organische elektrolumineszierende Bauteile beinhaltend Boranderivate.

Die Druckschrift WO 2005/062675 A1 betrifft Materialien für organische elektrolumineszierende Bauteile.

Dies bewirkt zusätzlich eine Absenkung der Betriebsspannung bei gleicher Effizienz der OLED. Diese Materialien sind starke Elektronendonoren und werden in geringer Menge in die Elektronentransportschicht bzw. in die Emitterschicht der OLED dotiert. Dadurch erleichtern solche Zusätze die Reduktion des Elektronentransportmaterials bzw. des Emittermaterials(also die Elektronenaufnahme in das LUMO [tiefstes unbesetztes Molekülorbital] des Elektronentransport-, bzw. Emittermaterials) was sonst ausschließlich durch die Energie des elektrischen Feldes bewirkt wird. Infolgedessen wird also bei schwächerem, elektrischem Feld (das einer geringeren Betriebsspannung entspricht) die gleiche Effizienz erreicht.

Bei den bisherigen bekannten Materialien sind die Stabilität und der injektions- und elektronentranportfördernde Effekt jedoch noch nicht zufrieden stellend.

Aufgabe der vorliegenden Erfindung ist es deshalb, ein Material zur Verbesserung der Elektroneninjektion und/oder des Elektronentransportes in organischen Bauelementen zu schaffen, das die Nachteile des Standes der Technik, insbesondere die fehlende Stabilität des injektions- und elektronentransport-fördernden Effekts zu erhöhen.

Die Lösung der Aufgabe und Gegenstand der Erfindung werden in den Ansprüchen, den Beispielen und der Beschreibung offenbart.

Erfindungsgemäß kann der injektions- und elektronentranportfördernde Effekt durch die neuen sterisch gehinderten Donorarylborane der Substruktur 2 und der nicht beanspruchten Substruktur 1 noch weiter verstärkt werden. Die Materialien sind außerdem luftstabil, hydrolyseun empfindlich und sublimierbar.

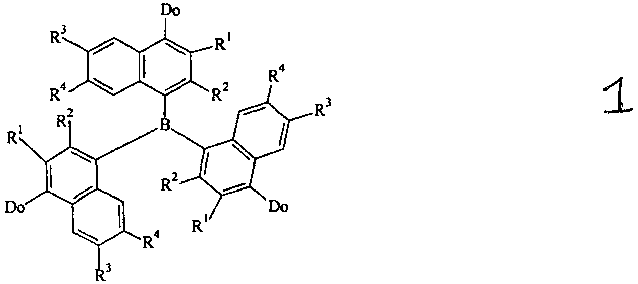

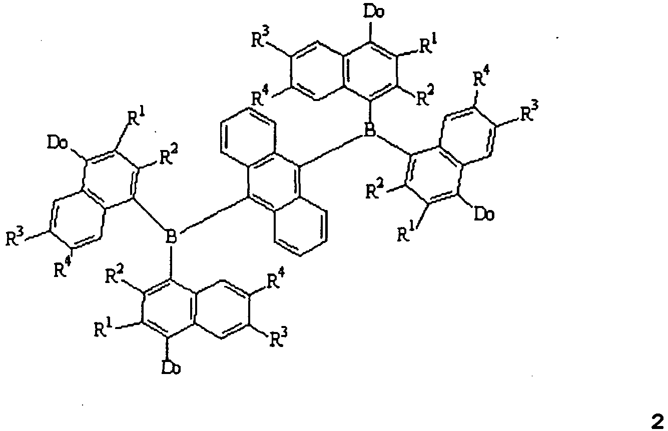

Dabei gilt folgendes:
Do entspricht einem Elektronendonor, der entweder eine aromatisch substituierte Amingruppe ist oder eine Gruppe, die ausgewählt ist aus Thiophenen, alkylsubstituierten oder Schwefel tragenden mehrkernigen aromatischen Systemen, besonders geeignet ist Stickstoff, der durch Aromaten (Phenyl oder Naphthyl) substituiert ist.
R¹ und R² bilden entweder einen weiteren anellierten aromatischen Ring oder R¹ bildet ein Brückenglied zu einem Donorsubstituenten, besonders geeignet ist Schwefel, R² ist in diesem Fall H oder Methyl.
R³ und R⁴ können Wasserstoff sein oder bilden gemeinsam einen anellierten aromatischen Ring.

Typische Elektronendonoren sind aromatische Systeme und alle elektronenreiche Systeme wie Thiophene, alkylsubstituierte oder Schwefel tragende mehrkernige aromatische Systeme, und alle wenig elektronegativen Substituenten, bevorzugt elektronenreiche wenig elektronegative Substituenten.

Die neuen Materialien, die geeignet sind den Elektronentransport und die Elektroneninjektion durch chemische Wechselwirkung mit beliebigen Elektronentransport- und/oder Emitterschichten zu verbessern können somit universell in polymerelektronischen Bauelementen erfolgreich eingesetzt werden, darunter werden vorrangig alle Technologien zur Herstellung von organischen Leuchtdioden (OLEDs), organischen Feldeffekttransistoren (OFETs) und organischen Solarzellen verstanden.

### Vergleichsbeispiel:

1)
   a) Synthese von 9-Diphenylamino-anthracen durch Heckkupplung aus Diphenylamin und 9-Bromanthracen.
   b) Synthese von 10,10,10-Tris-9-diphenylamino-anthryl-boran aus 9-Diphenylamino-anthracen, BuLi und Bortribromid bei -70°C. 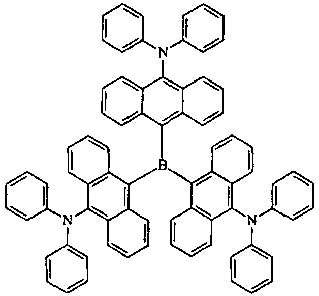
2)
   a)Synthese von 3-Methyl-1-naphthylamin nach Beilstein Handbuch 12,II,744.
   b)Synthese von 1-Diphenylamino-3-methyl-naphthalin durch Heckkupplung aus 3-Methyl-1-naphthylamin und Brombenzol.
   c) Synthese von Benzo-f-6-methyl-10-phenyl-phenothiazin aus 1-Diphenylamino-3-methyl-naphthalin und Schwefel.
   d) Synthese von 7,7,7-Tris-benzo-f-6-methyl-10-phenyl-phenothiazinyl-boran aus Benzo-f-6-methyl-10-phenyl-phenothiazin, BuLi und Bortribromid bei -70°C.

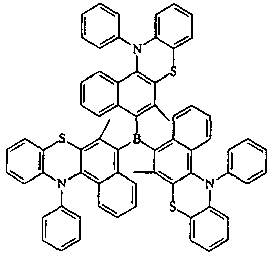

### Ausführungsbeispiel:

1)
   a) Synthese von 9-Diphenylamino-anthracen durch Heckkupplung aus Diphenylamin und 9-Bromanthracen.
   b) Synthese von Tetra-(9-diphenylamino-anthr-10-yl)-9,10-anthrylendiboran aus 9,10-Dibromanthracen, 9-Diphenylamino-anthracen, BuLi und Bortribromid bei -70°C.

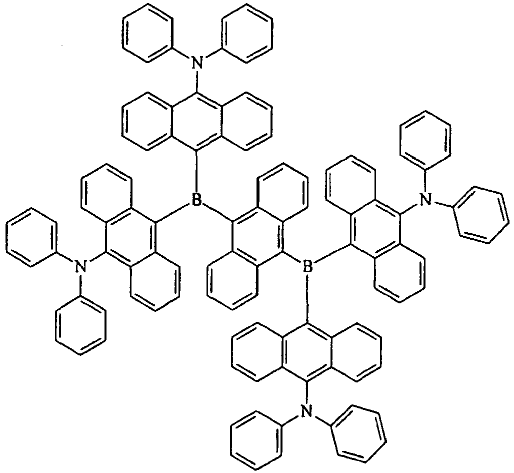

Die Erfindung betrifft neue Materialien auf Basis von sterisch gehinderten Donorarylboranen zur Verbesserung der Elektroneninjektion und des Elektronentransportes in organischen elektronischen Bauelementen wie organischen Leuchtdioden (OLEDs), organischen Feldeffekttransistoren (OFETs) und Bauelementen auf Basis organischer Photovoltaik wie insbesondere organischen Solarzellen.

## Patentansprüche

1. Material zur n-Dotierung der Elektronentransportschicht in organischen elektronischen Bauelementen zumindest eine Komponente gemäß des sterisch gehinderten Donorarylborans der Substruktur 2 umfassend, 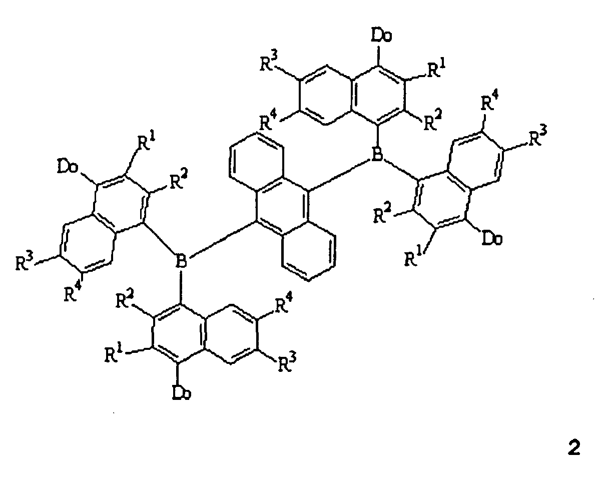 wobei
Do einem Elektronendonor entspricht, der entweder eine aromatisch substituierte Amingruppe ist oder eine Gruppe, die ausgewählt ist aus Thiophenen, alkylsubstituierten oder Schwefel tragenden mehrkernigen aromatischen Systemen,
R¹ und R² bilden entweder einen weiteren anellierten aromatischen Ring oder R¹ bildet ein Brückenglied zu einem Donorsubstituenten, besonders geeignet ist Schwefel, R² ist in diesem Fall H oder Methyl,
R³ und R⁴ können Wasserstoff sein oder bilden gemeinsam einen anellierten aromatischen Ring.

2. Material nach Anspruch 1, wobei Do in der Struktur 2 ausgewählt aus der Gruppe funktioneller Gruppen, die Amingruppe mit Phenyl oder Naphthyl substituiert ist.

3. Verwendung des sterisch gehinderten Donorarylborans der Substruktur 2, 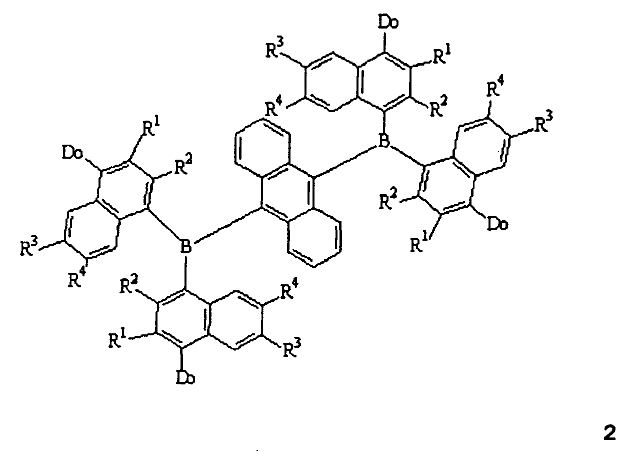 wobei
Do einem Elektronendonor entspricht,
R¹ und R² bilden entweder einen weiteren anellierten aromatischen Ring oder R¹ bildet ein Brückenglied zu einem Donorsubstituenten, besonders geeignet ist Schwefel, R² ist in diesem Fall H oder Methyl,
R³ und R⁴ können Wasserstoff sein oder bilden gemeinsam einen anellierten aromatischen Ring
zur n-Dotierung einer Elektronentransportschicht oder einer Emitterschicht eines organischen elektronischen Bauelements.

4. Organisches elektronisches Bauelement zumindest zwei Elektroden mit einer aktiven Schicht umfassend, wobei zwischen zumindest einer Elektrode und der aktiven Schicht eine Elektronentransportschicht oder eine Emitterschicht angeordnet ist, die dotiert ist mit einem sterisch gehinderten Donorarylboran der Substruktur 2, 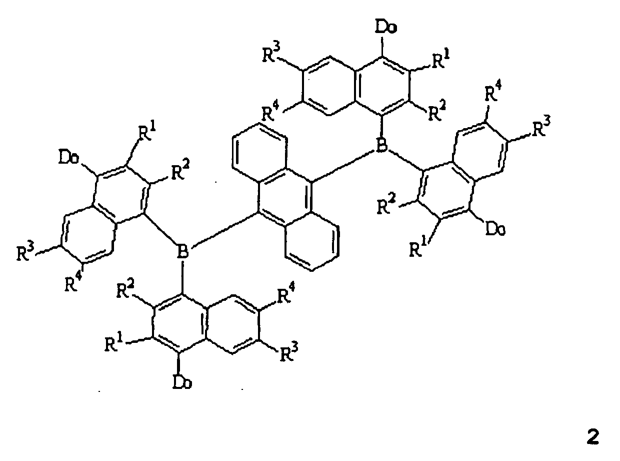 wobei
Do einem Elektronendonor entspricht,
R¹ und R² bilden entweder einen weiteren anellierten aromatischen Ring oder R¹ bildet ein Brückenglied zu einem Donorsubstituenten, besonders geeignet ist Schwefel, R² ist in diesem Fall H oder Methyl,
R³ und R⁴ können Wasserstoff sein oder bilden gemeinsam einen anellierten aromatischen Ring.

## Claims

1. Material for n-doping of the electron transport layer in organic electronic components, comprising at least one sterically hindered donor arylborane component of the substructure 2 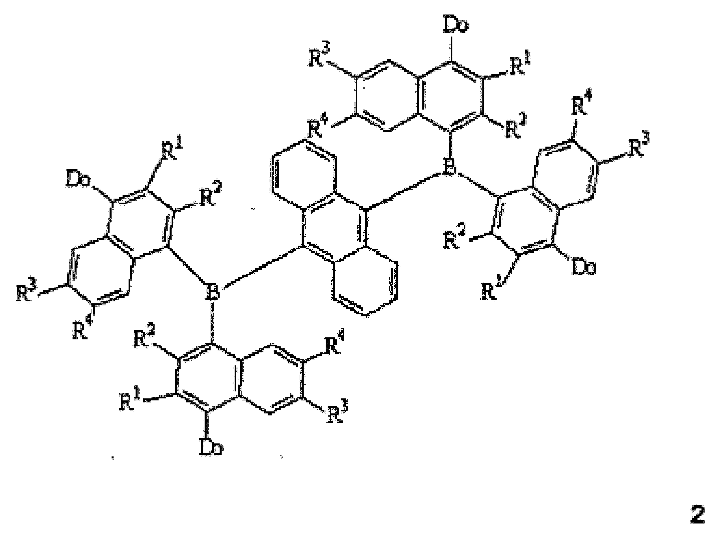 where
Do is an electron donor which is either an aromatically substituted amine group or a group selected from thiophenes, alkyl-substituted or sulphur-bearing polycyclic aromatic systems,
R¹ and R² either form a further fused aromatic ring or R¹ forms a bridging member to a donor substituent, sulphur being particularly suitable, in which case R² is H or methyl,
R³ and R⁴ may be hydrogen or together form a fused aromatic ring.

2. Material according to Claim 1, wherein Do in the structure 2 is selected from the group of functional groups, the amine group is substituted by phenyl or naphthyl.

3. Use of the sterically hindered donor arylborane of the
substructure 2 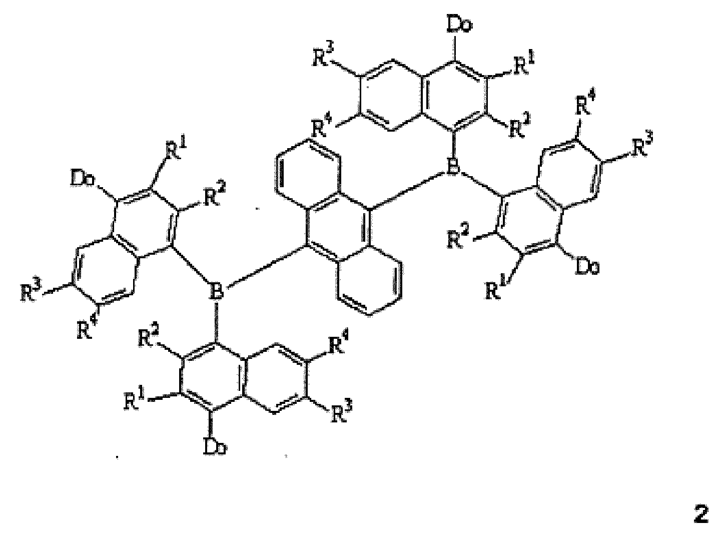 where
Do is an electron donor,
R¹ and R² either form a further fused aromatic ring or R¹ forms a bridging member to a donor substituent, sulphur being particularly suitable, in which case R² is H or methyl,
R³ and R⁴ may be hydrogen or together form a fused aromatic ring,
for n-doping of an electron transport layer or of an emitter layer of an organic electronic component.

4. Organic electronic component comprising at least two electrodes with an active layer, wherein an electron transport layer or an emitter layer arranged between at least one electrode and the active layer is doped with a sterically hindered donor arylborane of the substructure 2 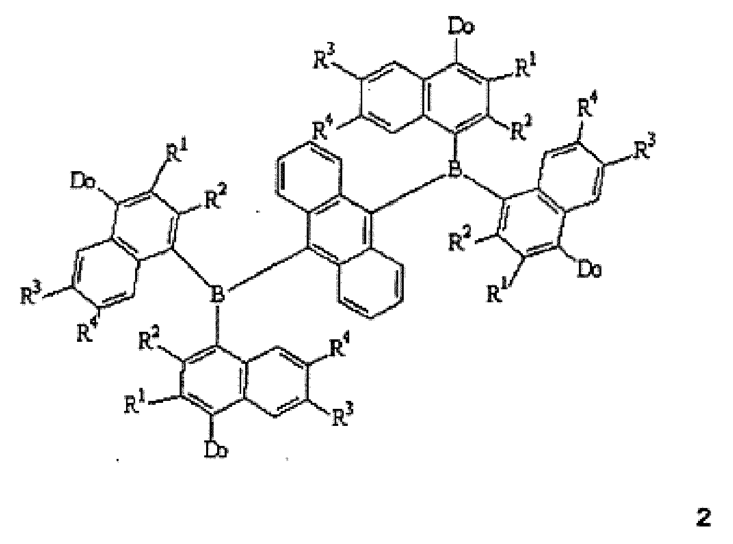 where
Do is an electron donor,
R¹ and R² either form a further fused aromatic ring or R¹ forms a bridging member to a donor substituent, sulphur being particularly suitable, in which case R² is H or methyl,
R³ and R⁴ may be hydrogen or together form a fused aromatic ring.

## Revendications

1. Matériau pour le dopage de type n de la couche de transport d'électrons dans des composants électroniques organiques, comprenant au moins un constituant conforme à l'arylborane donneur à empêchement stérique ayant la sous-structure 2 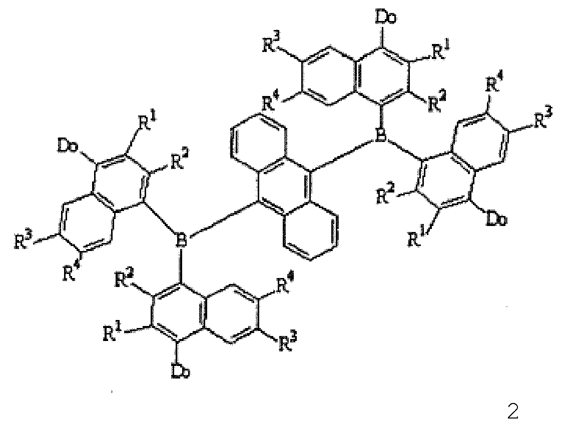 dans laquelle
Do correspond à un donneur d'électrons qui est soit un groupe amine à substitution aromatique, soit un groupe qui est choisi parmi des thiophènes, des systèmes aromatiques polynucléaires soufrés ou substitués par alkyle,
soit R¹ et R² forment un autre cycle aromatique soudé, soit R¹ forme un chaînon portant qui fait la liaison avec un substituant donneur, un atome de soufre est particulièrement approprié, R² est en ce cas H ou le groupe méthyle,
R³ et R⁴ peuvent être des atomes d'hydrogène ou forment ensemble un cycle aromatique soudé.

2. Matériau selon la revendication 1, dans lequel Do dans la structure 2 est choisi dans l'ensemble des groupes fonctionnels, le groupe amino est substitué par phényle ou naphtyle.

3. Utilisation de l'arylborane donneur à empêchement stérique ayant la sous-structure 2 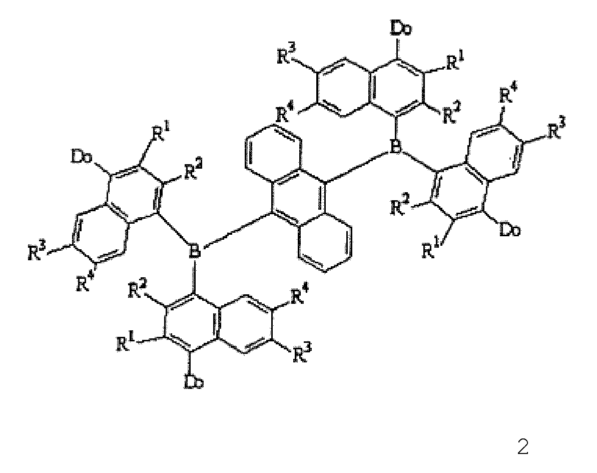 dans laquelle
Do correspond à un donneur d'électrons,
soit R¹ et R² forment un autre cycle aromatique soudé, soit R¹ forme un chaînon portant qui fait la liaison avec un substituant donneur, un atome de soufre est particulièrement approprié, R² est en ce cas H ou le groupe méthyle,
R³ et R⁴ peuvent être des atomes d'hydrogène ou forment ensemble un cycle aromatique soudé,
pour le dopage de type n d'une couche de transport d'électrons ou d'une couche émettrice d'un composant électronique organique.

4. Composant électronique organique comprenant au moins deux électrodes avec une couche active, entre au moins une électrode et la couche active étant disposée une couche de transport d'électrons ou une couche émettrice qui est dopée avec un arylborane donneur à empêchement stérique ayant la sous-structure 2 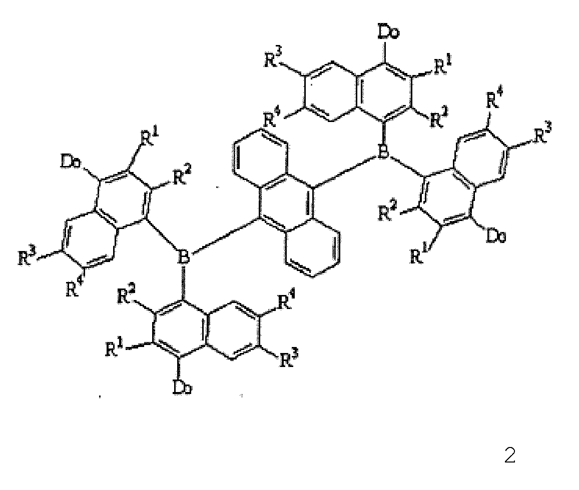 dans laquelle
Do correspond à un donneur d'électrons,
soit R¹ et R² forment un autre cycle aromatique soudé, soit R¹ forme un chaînon portant qui fait la liaison avec un substituant donneur, un atome de soufre est particulièrement approprié, R² est en ce cas H ou le groupe méthyle,
R³ et R⁴ peuvent être des atomes d'hydrogène ou forment ensemble un cycle aromatique soudé.
